Europäisches Patentamt

European Patent Office

Office européen des brevets

(11) EP 0 853 364 A2

(19)

(12) EUROPEAN PATENT APPLICATION

(43) Date of publication:
15.07.1998 Bulletin 1998/29

(51) Int Cl.⁶: **H02H 7/26**, G01R 21/133

(21) Application number: 97203863.2

(22) Date of filing: 10.12.1997

(84) Designated Contracting States:
**AT BE CH DE DK ES FI FR GB GR IE IT LI LU MC NL PT SE**
Designated Extension States:
**AL LT LV MK RO SI**

(30) Priority: 10.12.1996 IT MI962579

(71) Applicant: **ABB SACE S.p.A.**
**I-24100 Bergamo (IT)**

(72) Inventors:
• **Mariani, Maurizio**
  **22100 Como (IT)**
• **Lorito, Fabrizio**
  **20135 Milano (IT)**

(74) Representative: **Giavarini, Francesco**
  **ABB Ricerca S.p.A.**
  **Viale Edison, 50**
  **20099 Sesto San Giovanni (MI) (IT)**

(54) **Method for measuring a single electrical power load in electrical distribution networks**

(57)     In an electrical distribution network, a measurement of a single electrical power load is obtained. With this objective, the effective value of the voltage (V) and its frequency (f) are measured in the protection and control device (3) of the primary switch of a board (2), while the protection and control device (21) associated with the particular load (10) measures the effective current (I1) and the phase angle (Φ) between voltage and current is determined by measuring the difference between the instant (tl) of zero crossing of the voltage (V) and that (t2) of the current (I1) in the load (10).

FIG. 1

EP 0 853 364 A2

## Description

The present invention relates to a method for measuring a single electrical power load in electrical distribution networks.

An electrical distribution network generally comprises a primary switch which receives the supply from the line and distributes it to a plurality of loads or consumers connected to a distribution bar. Each of the loads is connected to the bar via its own switch comprising a protection and control device.

The device intervenes, opening the associated switch, when it detects anomalous conditions in the load, typically an overload, a short-circuit or an earth fault, and performs control functions such as acquisition of the state of the switch and its actuation. Normally, these protection and control devices, even in the most modern and technologically advanced versions, which are equipped with a microprocessor, execute measurements of current only. Also known are systems referred to as distributed automation systems, which comprise a channel or bus (field bus) for exchanging data, which connects all the protection and control devices to one another and possibly to a supervision and control unit located in a control room. A main clock delivers a time reference.

In systems of this type, however, the field bus is used only as the medium for exchanging data between the devices installed in the field and the higher-level unit, in view of the remoteness of the supervision and control functions. Moreover, such devices are capable of delivering information relating only to interruptions or anomalous conditions.

In network which supplies a plurality of consumers, there is however a requirement to obtain indications regarding the actual power used by the individual consumers, in addition to the usual tasks explained above. The objective of such a measurement is to monitor the individual consumers, for the purpose of deciding the possible strategies for optimizing consumption. The known supervision and control systems, as indicated previously, are not capable of satisfying this requirement because the protection and control devices are not suitable, and replacing them with other more complex ones would not be economically acceptable.

The objective of the present invention is to overcome the limitations and drawbacks indicated above of the systems known in the prior art, in particular by making it possible to measure the power used by each consumer without appreciable modifications of the known devices, for an extremely modest cost and with an acceptable level of accuracy of measurement.

These objectives are achieved with the invention which consists of a method for measuring a single electrical power load in an eletrical power distribution network, characterized in that it provides for the following steps:

a) measuring the value of the effective voltage and its frequency at a point upstream of the said load at which the value of the voltage is substantially equal to the value applied to the load;
b) measuring the current flowing in at least one load and the phase angle with respect to the said effective voltage;
c) multiplying the value of the effective voltage by the said values of current in the load and phase angle, and sending this information, over a common computer line, to the eletrical power distribution network.

The invention also relates to a distributed automation system comprising at least one switch connected to a supply line and to an associated protection and control device, and a distribution bar connected between the switch and at least one load, said load being provided with an associated protection and control device, characterized in that the said protection and control device comprises means for measuring the current flowing in the corresponding load and the phase angle with respect to the effective voltage applied to the said load.

The invention will now be described with reference to the appended drawings relating to a preferred but non-limiting embodiment of the invention; in particular, the invention applies in medium and low-voltage systems.

Figure 1 shows a general electrical diagram of a system designed according to the invention;
Figure 2 illustrates a block diagram of the measurement part of a protection and control device.

In contrast to what happens in prior art systems, the solution proposed by the invention provides for the use of a peer-to-peer bus for communicating between the devices of the electrical network, making available to the various devices, information and measurements which are normally not available to them. In other words, for example, the measurement of voltage is performed only near to the primary switch (for example of a low-voltage board), and is communicated to other devices along the communication system. The information relating to the voltage includes the effective value of the voltage and the instant at which it passes through zero.

As is known, the actual electrical power load under sinusoidal conditions is given by:

$$P = V.I. \cos\Phi$$

where

V is the effective value of the voltage across the load;
I is the effective value of the current flowing in the load;

Φ is the phase angle or phase offset between voltage and current.

The angle Φ is calculated by determining the instants t1 and t2 of zero crossing, respectively of the voltage and of the current, according to the relation:

$$\Phi = (t1 - t2) / (2\pi/T)$$

where T = 1/f is the period of the sinusoidal voltage.

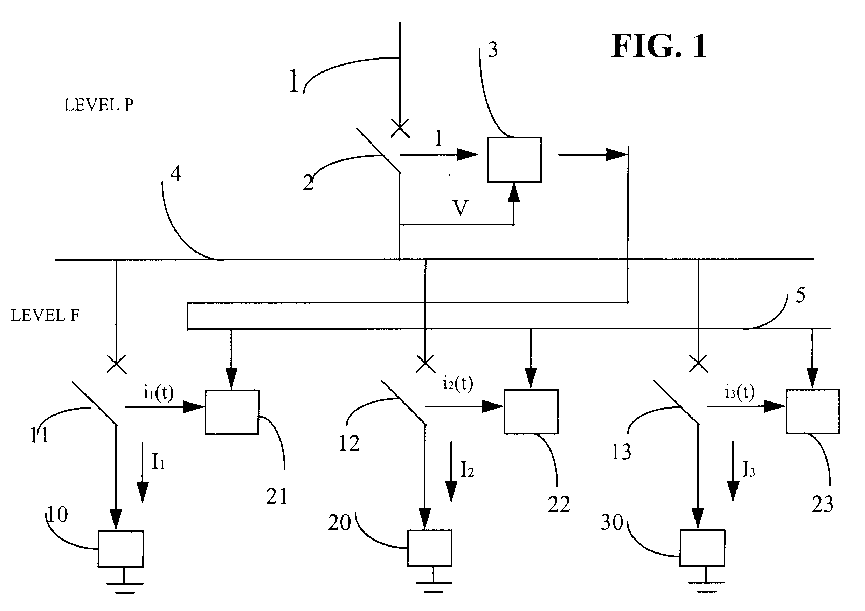

According to the invention, considering a level P higher than that F of the loads (Figure 1), there exist operations which must definitely be executed at level P: such as measurement of the effective voltage (V) and its frequency (f) and calculation of t1; and operations which must definitely be executed at level F, such as measurement of the effective current (I) and measurement of t2.

These are also operations which can be carried out either at level P or F, such as for example calculation of (t2-t1), calculation of φ and of cosΦ and the final calculation VIcosΦ.

With reference to the diagram of Figure 1, the distribution network according to the invention comprises an LV supply line 1, connected to the upstream contact of a primary switch 2 of the board, and a protection and control device 3, also called "node".

A distribution bar 4 is connected to the downstream contact of the switch 2 on the one hand and, via switches 11, 12, 13, to consumers or loads 10, 20, 30. For illustrative simplicity, only three loads are shown in the drawing, but it is obvious that the number of consumers connected is arbitrary.

Each switch 11, 12, 13 is controlled by a corresponding protection and control device, 21, 22, 23, capable of interveining upon the occurrence of anomalous conditions of operation of the load, which are determined by the measurement of the effective value of the current I1, I2, I3 performed by the device 3.

The protection and control devices 21, 22, 23, also termed nodes, are connected together and to the protection and control device 3 associated with the primary switch 2, through a communication bus 5.

According to the invention, the distributed system is capable of calculating each electrical power load in the network.

The manner of calculating the single electrical power load will be illustrated, by way of example, for the load 10, but it is obvious that it applies to any of the loads connected. As is known, the actual power used by a load under sinusoidal conditions is given by:

$$P = V.I.\cos\Phi$$

where

V is the effective value of the voltage across the load;
I is the effective value of the current flowing in the load;
Φ is the phase angle or phase offset between voltage and current.

In the system according to the invention it is supposed that the voltage V across the load is substantially equal to that present on the distribution bar 4.

According to the invention, the protection and control device 3 is capable of measuring not only the total current I but also the effective value V of the line voltage, its frequency f and the instant t1 of zero crossing of the voltage V. It is moreover capable of periodically transmitting, in a known manner, this information to the control device of any one of the loads, for example to the device 21 in the example illustrated.

The angle Φ is calculated by determining the instants t1 and t2 of zero crossing, respectively of the voltage and of the current, according to the relation:

$$\Phi = (t1 - t2)/(2\pi/T)$$

where T = 1/f is the period of the sinusoidal voltage.

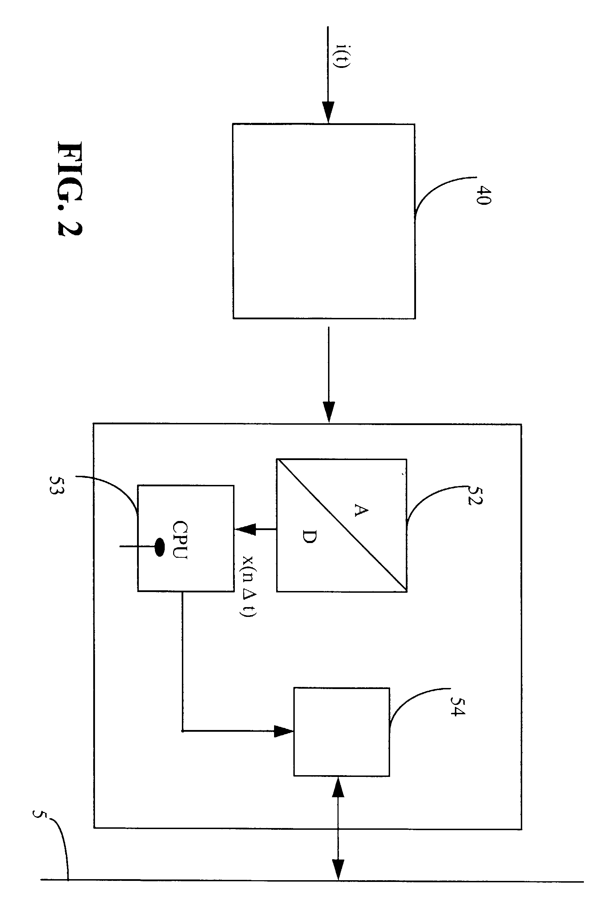

The instant tl is determined by the primary protection and control device 3 and periodically transmitted to the nodes, in this case to the device 21, by means of the communication system which employs the bus 5. The instant t2 is calculated locally by the device in question (21 in this case) by means of the procedure explained with reference to the circuit represented diagrammatically in Figure 2, which may already be substantially present in the protection device for calculation of the value of the current.

This circuit comprises a block 40 which receives as input a current i(t) proportional to that flowing in the load (I1 in the example considered), and which outputs a proportional current which is input to an analog/digital converter 52 which produces sampled outputs coded into binary code and representative of the values taken by the current. A processing unit or CPU 53 determines the effective value of this current. This value is sent via a communication card 54 to the data bus 5.

The CPU 53 contains a digital filter for the effective value and a comparator for identifying the zero crossing of the current i(t).

As has been stated, the circuit is preferably implemented by means of a suitable program which controls the CPU, and which is already present in known protection and control devices and serves to periodically communicate the value of the current in the load. Typically, the unit 53 consists of a low-cost processing unit, such as an 8-bit microcontroller, or an applications specific integrated circuit (ASIC), furnished with an analog/digital converter.

The CPU 53 also incorporates the comparator for identifying the instant t2, i.e. the instant of zero crossing of the current i(t).

In particular the CPU 53, by comparing the values of the samples with a reference threshold very close to zero, is capable of pinpointing an instant t3 (taken with reference to the clock ofthe CPU 53) such that:

$$t3 = del. + t2$$

where del. is the delay, quantifiable and measurable, introduced by the acquisition chain and by the digital filter.

Should there be no rectifier provided in the block 40, the calculation of t2 is immediate and different processes are available for Ieff (e.g. the maximum is calculated and is divided by $\sqrt{2}$).

The invention has been described with reference to particular and preferred embodiments, however it is not limited to what was descibed, but embraces the variants and modifications which will be evident to a person skilled in the art.

## Claims

1. Method for measuring a single electrical power load (10, 20, 30) in an eletrical power distribution network (4), characterized in that it comprises the following operational steps:

   a) measuring the value of the effective voltage (V) and its frequency at a point upstream of the load (10) at which point the value of the voltage is substantially equal to the value applied to said load (10);
   b) measuring the current (I1) flowing in at least one load (10) and the phase angle ($\Phi$) with respect to the effective voltage (V);
   c) multiplying the value of the effective voltage (V) by the said values of current (I1) in the load (10) and phase angle ($\Phi$), and sending this information, over a common computer line (5), to the eletrical power distribution network (4).

2. Method, according to Claim 1, characterized in that the phase angle ($\Phi$) is measured at a point of the network other than the load (10) and the corresponding information is transmitted along the common channel (5).

3. Method, according to Claim 1 or 2, employed in an eletrical power distribution network (4) comprising a main switch (2) connected to a supply line (1) and an associated protection and control device (3), and a distribution bar (4) connected between the said switch (2) and a plurality of loads (10, 20, 30), each furnished with an associated protection and control device (21, 22, 23); characterized in that the measurement of the value of the effective voltage (V) is performed in the vicinity of the protection and control device (3) of the main switch (2), and the measurements of the current (I1) and of the phase angle ($\Phi$) are performed in the protection and control device (21, 22, 23) associated with the load (10, 20, 30) of which it is desired to measure the power used.

4. Method, according to Claims 1 to 3, characterized in that the common computer line (5) is a digital data bus.

5. Distributed automation system comprising at least one main switch (2) connected to a supply line (1) and to an associated protection and control device (3), and a distribution bar (4) connected between the switch (2) and at least one load (10, 20, 30), each furnished with an associated protection and control device (21, 22, 23), characterized in that each of the protection and control devices (21, 22, 23) comprises means for measuring the current (I1) flowing in the corresponding load (10) and the phase angle ($\Phi$) with respect to the effective voltage applied to the load.

6. Distributed automation system, according to Claim 5, characterized in that each of the protection and control devices (21, 22, 23) incorporates a block (40) which receives as input a current (i(t)) proportional to that (I1, I2, I3) flowing in the load, an analog/digital converter (52), a processing unit (53) and a communication card (54).

7. Distributed automation system, according to Claim 6, characterized in that the processing unit (53) comprises a digital filter for the effective value and a comparator for identifying the crossing of the current (i(t)) through the zero value.

FIG. 1

**FIG. 2**

i(t)

40

52

A
D

x(nΔt)

CPU

53

54

5